# EUROPEAN PATENT APPLICATION

(11) **EP 3 073 533 A1**
(43) Date of publication of application: **28.09.2016**
(21) Application number: 15828628.6
(22) Date of filing: 19.05.2015
(51) Int. Cl.: H01L 31/0216, H01L 31/048

(54) **SOLAR PHOTOVOLTAIC POWER GENERATION MODULE**

(30) Priority: 27.08.2014 JP 2014172873
(71) Applicant: Moresco Corporation, Kobe-shi, Hyogo 650-0047 (JP)
(72) Inventor: YOSHIDA Toru, Kobe-city Hyogo 650-0047 (JP); KISHIMOTO Yasukazu, Kobe-city Hyogo 650-0047 (JP)
(74) Representative: advotec.
(86) International application number: PCT/JP2015/064329
(87) International publication number: WO 2016/031315

(57) **Abstract**

The invention has for its object to provide a solar photovoltaic generation module capable of being used over an extended period of time while keeping on its performance.

The solar photovoltaic generation module of the invention comprises at least an outer frame, a transparent substrate, a sealing material and a back sheet, each working as a structural member, and either one of the following functional member combinations: (A) a cell and an interconnector, and (B) a transparent electrode, a photovoltaic layer and a back-surface electrode. At least a part or the whole of the surface of any one of the members is covered with a coating film of a water-repellent surface modifier material.

## Description

### Technical Field

The present invention relates to a solar photovoltaic generation module capable of holding back a so-called PID (potential induced degradation) phenomenon responsible for considerable performance degradations upon installed outdoors, etc. and achieving high power in a stable way.

### Background Art

Utilization of natural energies has attracted attention as possible preventives of global warming. Although there is a solar battery among available options, yet there is still much left to be desired in terms of higher conversion efficiency, higher weather resistance, and lower cost. A solar battery module (or solar photovoltaic generation module) that is a core of the photovoltaic function in particular is now required to be used over an extended period of time while maintaining higher conversion efficiency.

In recent industrial fields, solar photovoltaic generation modules such as multiple modules connected in series have increasingly been run at high voltages. However, it has already been known that such high voltage operation creates a high potential difference between the operating frame and the module, ending up with the aforesaid PID phenomenon where the photovoltaic generation capability dwindles drastically. To improve the efficiency of utilization of the ensuring electricity, the running voltage of solar batteries will keep on growing high from now on. In other words, solar photovoltaic generation module design capable of preventing the PID from occurring even upon running at higher voltages is still in greater demand.

As indicated typically in AGC, PV JAPAN 2013, Materials-Specific Experts Seminar Papers (2013) (Non-Patent Publication 1), the PID is caused by ingress of water into a photovoltaic generation module or the migration of sodium ions through a cover glass used as a transparent substrate member to prevent ingress of water into a photovoltaic generation module. Although there have been various actions taken to prevent this PID such as the use of such a high insulating cell sealing material as set forth in JP(A) 2014-11270 (Patent Publication 1) or the use of means for holding back the migration of sodium ions into a cell as set forth in JP(A) 2011-254116 (Patent Publication 2) or JP(A) 2013-254993 (Patent Publication 3), a fundamental resolution still remains to be seen.

In addition, as reported by P. Peng et al. in RSC Advances, Vol. 2, pp. 11359-11365, 2012 (Non-Patent Article 2), there are inconveniences known as a snail trail (also called a snail track) too. The snail trail is a phenomenon occurring primarily at an interface between a photovoltaic generation cell and a sealing material, leaving behind a trail "as if a snail were creeping". The snail trail is created through the formation of minute cracks in a cell silicon wafer, and water, oxygen and carbon dioxide are considered to take part in the snail trail.

As observed by S. Richter et.al. in "Proceedings of 27th European Photovoltaic Solar Energy Conference and Exhibition, 2012" (Non-Patent Article 3), a portion where the snail trail is found is blackened, grayed or otherwise discolored, and that discolored area contains, in addition to electrode components such as Ag in nanoparticle form, sulfur, phosphor or chlorine. The snail trail and inconveniences incidental to it are shown to be caused by degradations of the electrode and solder due to corrosion and peeling. Those inconveniences are considered to be caused ingress of moisture into the module, and acetic acid resulting from hydrolysis of the sealing material such as EVA. And these inconveniences, too, provide a factor giving rise to some considerable degradation of reliability of solar batteries as is the case with the PID, but they have difficulty in radical resolution, resulting in urgent need of rapid action.

### Prior Art

### Listing of the Patent Publications

Patent Publication 1: JP(A) 2014-11270
Patent Publication 2: JP(A) 2011-254116
Patent Publication 3: JP(A) 2013-254993

### Listing of the Non-Patent Publications

Non-Patent Publication 1: AGC, PV JAPAN 2013, Materials-Specific Experts Seminar Papers (2013)
Non-Patent Publication 2: P. Peng et al., RSC Advances, Vol. 2, pp. 11359-11365, 2012
Non-Patent Publication 3: S. Richter et al., Proceedings of 27th European Photovoltaic Solar Energy Conference and Exhibition, 2012

### Summary of the Invention

### Object(s) of the Invention

In order to provide a solution to the aforesaid problems, the present invention has for its object to provide a solar photovoltaic generation module that is capable of improving photovoltaic efficiency in a simple yet inexpensive way, and eliminating or holding back the PID or snail trail that is a chief cause of performance degradations, or inconveniences incidental to them.

### How to Achieve the Object(s)

For the purpose of improving photovoltaic efficiency and solving the aforesaid problems, the inventors have looked into the members or parts in a solar photovoltaic module on a molecular level to make study after study and go deep into various conditions while taking care of the importance of cost. As a result, the inventors have found out that the addition of given physical properties to the surfaces of various members within and without a solar photovoltaic module makes the PID phenomenon less likely to occur. In other words, the object(s) of the invention is accomplished by the inventions embodied as follows.
[1] A solar photovoltaic generation module, comprising:
   at least an outer frame, a transparent substrate, a sealing material and a back sheet, each working as a structural member, and either one of the following functional member combinations: (A) a cell and an interconnector, and (B) a transparent electrode, a photovoltaic layer and a back-surface electrode, wherein at least a part or the whole of the surface of any one of said members is covered with'a coating film of a water-repellent surface modifier material.
[2] A solar photovoltaic generation module as recited in [1], wherein the coating film of said surface modifier material has a sheet resistance of at least 100 Ω/sq under a condition having a 85% RH humidity.
[3] A solar photovoltaic generation module as recited in [1] or [2], wherein said coating film has a water contact angle of at least 50 degrees.
[4] A solar photovoltaic generation module as recited in any one of [1] to [3], wherein the coating film of said surface modifier material has a water sliding angle of 0.5 degrees to 60 degrees inclusive.
[5] A solar photovoltaic generation module as recited in any one of [1] to [4], wherein the coating film of said surface modifier material has a refractive index equal to or less than that of said transparent substrate member and cell member.
[6] A solar photovoltaic generation module as recited in any one of [1] to [5], wherein the coating film of said surface modifier material has a light ray transmittance equal to or greater than that of the transparent substrate member and cell member.
[7] A solar photovoltaic generation module as recited in any one of [1] to [6], wherein said surface modifier material is any one of a solvent solution type resin, a thermosetting type resin, and an ultraviolet curing type resin.
[8] A solar photovoltaic generation module as recited in any one of [1] to [7], wherein the coating film of said surface modifier material is formed on the surface of one or two or more members selected from said outer frame member, said transparent substrate member, and said back sheet member.
[9] A solar photovoltaic generation module as recited in any one of [1] to [8], wherein the coating film of said surface modifier material is formed on a portion of each member coming into contact with air.
[10] A solar photovoltaic generation module as recited in any one of [1] to [7], wherein the coating film of said surface modifier material is formed on a part or the whole of the surface of the cell member.
[11] A solar photovoltaic generation module as recited in any one of [1] to [8], wherein the coating film of said surface modifier material is formed on a part or the whole of the inside of the substrate.

### Advantages of the Invention

According to the invention, it is possible to improve photovoltaic efficiency in an inexpensive yet simple way, eliminate or hold back the PID or snail trail that is a chief cause for poor output, or inconveniences incidental to them so that the reliability and service, life of solar photovoltaic generation modules are improved, contributing much more to making sure stable output over an extended period of time and mass production as well.

### Brief Explanation of the Drawings

Fig. 1 is illustrative in schematic of one aspect of the solar photovoltaic generation module according to the invention.
Fig. 2 is illustrative in schematic of another aspect of the solar photovoltaic generation module according to the invention.
Fig. 3 is a photograph as a substitute for a drawing, showing a light emitting state of Inventive Sample 1 in Example 1.
Fig. 4 is a photograph as a substitute for a drawing, showing a light emitting state of Inventive Sample 1 left standing under high-temperature and high-humidity conditions in Example 1.
Fig. 5 is a photograph as a substitute for a drawing, showing a light emitting state of Comparative Sample 1 left standing under high-temperature and high-humidity conditions in Comparative Example 1.
Fig. 6 is a photograph as a substitute for a drawing, showing a light emitting state of Inventive Sample 2 left standing under high-temperature and high-humidity conditions in Example 2.
Fig. 7 is a photograph as a substitute for a drawing, showing a light emitting state of Inventive Sample 3 left standing under high-temperature and high-humidity conditions in Example 3.
Fig. 8 is a photograph as a substitute for a drawing, showing a light emitting state of Inventive Sample 4 left standing under high-temperature and high-humidity conditions in Example 4.

### Modes for Carrying Out the Invention

The solar photovoltaic generation module of the invention comprises at least an outer frame, a transparent substrate, a sealing material and a back sheet, each working as a structural member, and either one of the following functional member combinations: (A) a cell and an interconnector, and (B) a transparent electrode, a photovoltaic layer and a back-surface electrode, wherein at least a part or the whole of the surface of any one of said members is covered with a coating film of a water-repellent surface modifier material. Such covering of at least a part of the structural member(s) with the coating film of the water-repellent surface modifier material makes sure prevention of ingress of moisture thereby eliminating or holding back the occurrence of the PID.

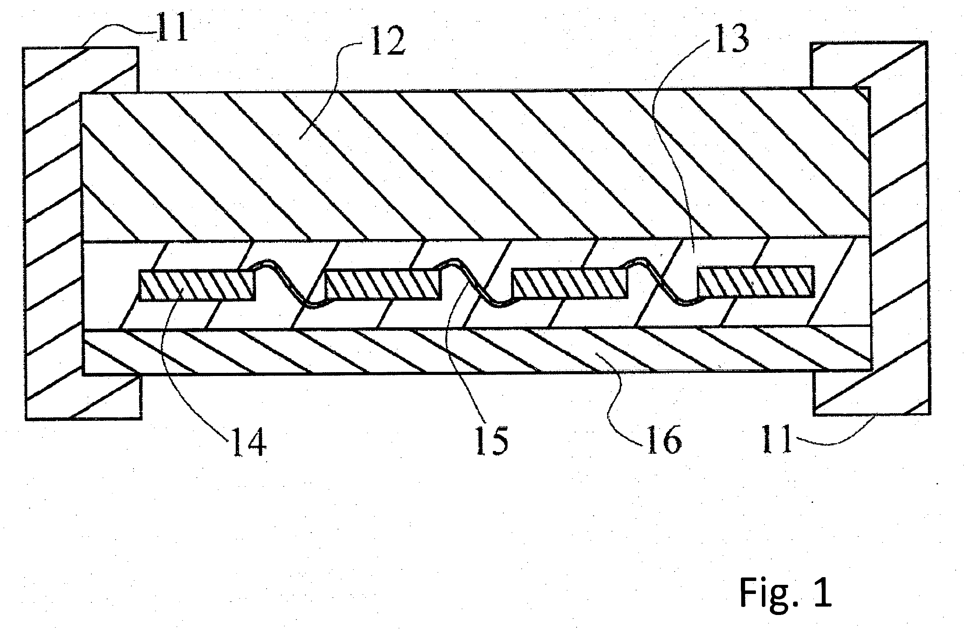

By way of example but not by way of limitation, one embodiment of the invention is now explained with reference to a sectional view illustrative of a typical solar photovoltaic generation module structure. Fig. 1 is a sectional view of (A) a solar photovoltaic generation module based on a crystal system: for its details, see the aforesaid Patent Publication 2. The solar photovoltaic generation module here basically includes at least an outer frame 11, a transparent substrate 12, a sealing material 13, a cell assembly 14, an interconnector 15, and a back sheet 16.

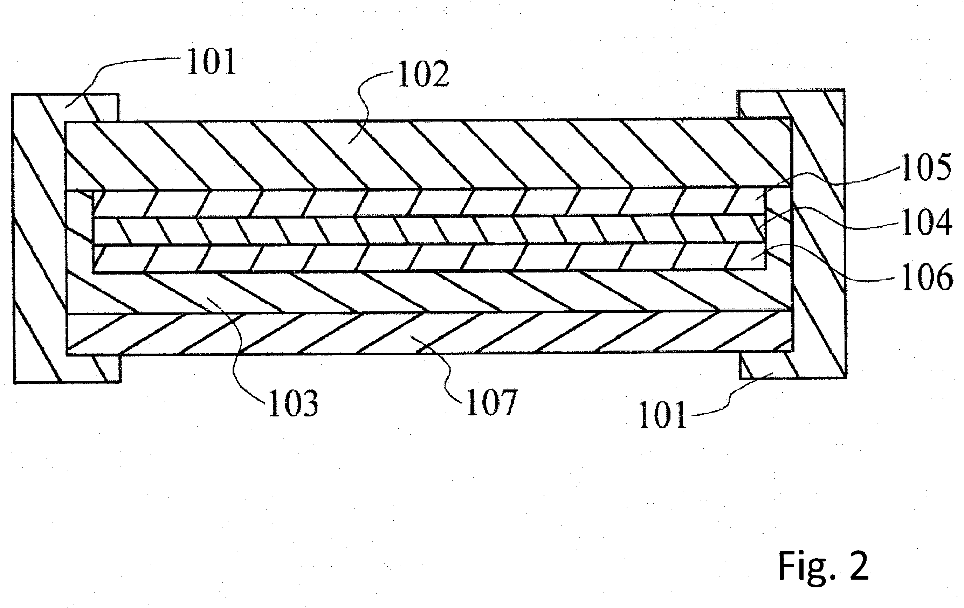

Fig. 2 is a sectional view of (B) a solar photovoltaic generation module based on an amorphous silicon or compound system: for its details, see JP(A) 2013-165232 or JP(A) 05-175529 as an example. The solar photovoltaic generation module here basically includes at least an outer frame 101, a transparent substrate 102, a sealing material 103, a photovoltaic layer 104, a transparent electrode 105, a back-surface electrode 106, and a back sheet 107.

Referring to the solar photovoltaic generation module illustrated in Fig. 1, solar light or light needed for power generation arrives at the cell assembly 14 through the transparent substrate 12, where it is photoelectrically converted and the ensuing power is taken out of the interconnector 15. Referring to the solar photovoltaic generation module illustrated in Fig. 2, on the other hand, solar light or light needed for power generation arrives at the photovoltaic generation layer 104 through the transparent electrode 105, where it is photoelectrically converted and the ensuring power is taken out of the transparent substrate 102 and back-surface electrode 106.

It is here to be noted that among the components in Figs. 1 and 2, the outer frame, transparent substrate, sealing material and back sheet are structural members used commonly in both the solar photovoltaic generation modules. The functional members taking direct part in photovoltaic generation function, on the other hand, are the cell assembly and interconnector in (A) the solar photovoltaic generation module based on a crystal system, and the transparent electrode, photovoltaic generation layer and back-surface electrode in (B) the solar photovoltaic generation module based on an amorphous silicon or compound system. Note again that the aforesaid components are essentially basic ones to which additional elements may be provided as needed.

It is here important that at least a part of the surface of any one of these components be covered with a coating film formed of a water-repellent modifier material. Among others, the functional members are of greater importance, and a part or the whole of the surface of any one of them in general, and a part or the whole of the surface of the cell assembly or a stack of the transparent electrode, photovoltaic generation layer and back-surface electrode in particular is preferably covered over. When the cell assembly is covered with the coating film, it is more effective to provide a covering as far as the interconnector. Further, when a local area of each member is covered with the coating film, it is preferable to provide the coating film all over one side surface of the cell assembly or all over the back-surface electrode side surface.

When the coating film cannot be formed over the functional member(s) for the reason of difficulty in the formation of the coating film over such a functional member(s) or cost considerations, some effects may be obtained even with the coating film over the surface of any one of the structural members. To be specific, the coating film of the surface modifier material may be formed over the surface of any one of the outer frame, transparent substrate, sealing material, and back sheet. The formation of the coating film over the inside surface of the transparent substrate, viz. on the sealing space side, too, is effective because the cell assembly can be prevented from contamination due to sodium ions, etc. present on the transparent substrate. It is also preferable to provide the coating film over at least a surface of contact of the transparent substrate with the cell assembly. Note here that when aluminum is used for the outer frame, it is preferable to use the one that is treated on its surface with anodized aluminum (aluminum oxide).

It is also effective to form the coating film of the surface modifier material on a coupling or junction between these members. It is most effective to form the coating film on only portions of these members in contact with air (the open air). It is a matter of course that the more the sites having the coating film formed on them and the larger the area occupied by the coating film, the more effective the coating film gets, and it is most effective to form the coating films on all of these sites.

In terms of specific values, at least 50%, and more preferably at least 80% of the surface of each component should be covered by the coating film of the surface modifier material. Of importance here is that a certain effect is obtainable by the covering of even a part of the component member with the coating film of the surface modifier material. The coating film of the surface modifier material has a thickness of preferably at least 1 nm, more preferably 5 nm to 500 nm inclusive, and most preferably 10 nm to 160 nm inclusive. Too thin a coating film is less likely to produce its own effect, and a coating film having a thickness greater than a certain value is rather less likely to vary in effect, ending up with material wastage.

The less the pores (openings) and cracks in the coating film of the surface modifier material, the more effective it is to prevent transfer of ultrafine mass such as ions or molecules and the less likely it is to give rise to migration of ions such as sodium ions in the module that cause the PID. The coating film, because of being of water repellency, makes it possible to obtain a solar photovoltaic general module less likely to undergo ingress of rainwater or atmospheric moisture.

### [Sheet Resistance]

Upon formation of the coating film of the surface modifier material on each member, it has a sheet resistance of at least 100 Ω/sq, preferably at least 500 Ω/sq, and more preferably 1000 Ω/sq under a humidity condition of 85% RH. If the sheet resistance is greater than the aforesaid value, the coating film is capable of effectively preventing performance degradations of the photovoltaic generation module by reason of the PID. Although the member's sheet resistance effective under the aforesaid humidity condition is at least 100 Ω/sq, it is to be understood that its upper limit is at most 10¹⁵ Ω/sq, and more preferably at most 10¹⁰ Ω/sq.

It is here noted that the resistance of painted coating films or thin films is usually estimated in terms of surface resistivity (unit: Ω/□ or Ω/sq). This resistance value is called a sheet resistance or surface resistance defined by a resistance value of an area having a unit square (1 cm²) through which an electric current flows from one direction in an opposite direction. The higher the water repellency of a coating film, the larger the sheet resistance grows. The temperature condition for measuring the electrical resistance of the surface of each member in the invention is preferably -40°C to 100°C, more preferably 15°C to 85°C, and even more preferably 20°C to 60°C.

### [Contact Angle of Water]

The larger the contact angle of the inventive coating film with water, the better the water repellency is; in other words, that coating film is capable of preventing ingress of water into the solar photovoltaic generation module enough to maintain its initial performance over an extended period of time outdoors, and easily removing contaminants deposited to the module as well. The contact angle may be measured by a contact angle gauge. Under conditions defined by a measurement temperature of 20°C to 50°C and a measurement humidity of 20% RH to 50% RH, the contact angle of the inventive coating film with water is preferably greater than 50 degrees to below 180 degrees, more preferably greater than 100 degrees to below 150 degrees, and even more preferably 100 degrees to below 140 degrees.

### [Sliding Angle of Water]

The smaller the sliding angle of the inventive coating film with respect to water, the better the water repellency is; in other words, that coating film is capable of preventing ingress of water into the solar photovoltaic generation module enough to maintain its initial performance over an extended period outdoors. The sliding angle may be measured by a sliding angle gauge. For instance, water droplets are first deposited onto the leveled surface of the coating film over each member forming a part of the solar photovoltaic module. The surface of the coating film is then allowed to tilt down little by little to measure the angle at which the water droplets slide down. The sliding angle effective here is 0.5 degree to 60 degrees inclusive, preferably 0.5 degree to 50 degrees inclusive, and more preferably 1 degree to 45 degree inclusive.

### [Refractive Index]

If the refractive index of the coating film itself applied to the inventive solar photovoltaic generation module is the same as that of the transparent substrate member or cell member, the photovoltaic efficiency upon the application of that coating film is then maintained on the same performance level as before the application of the coating film. If the refractive index of the coating film is less than that of the transparent substrate member or cell member, the photovoltaic performance is improved preferably about 0.5% to 3% by the antireflection effect.

### [Light Transmittance]

If the light ray transmittance of the coating film itself applied to the inventive solar photovoltaic generation module is the same as that of the transparent substrate member or cell member, the photovoltaic efficiency upon the application of that coating film is then maintained on the same performance level as before the application of the coating film. If the light ray transmittance of the coating film is greater than that of the transparent substrate member or cell member, the photovoltaic performance is improved about 0.5% to 3%. Note here that although a porous antireflection material is sometimes used for the transparent substrate member so as to improve photovoltaic efficiency, yet the inventive coating film may also prevent the PID induced by such an antireflection material because an additional water-repellent coating film is provided on that porous antireflection material.

### [Surface Modifier Material]

For the aforesaid surface modifier material, use may be made of any material having the aforesaid properties regardless of whether it is organic or inorganic. However, preference is given to a resinous material in view of ease of film formation and cost considerations. The resinous material used here may be any one of the solvent solution type, thermosetting type or ultraviolet setting type.

The solvent solution type resin refers to a resin providing a precursor for the formation of a coating film which precursor does not chemically change after the formation of the coating film; the thermosetting type resin refers to a resin providing a precursor for the formation of a coating film which precursor is set by heat; and the ultraviolet (or radiation inclusive of light) setting type resin refers to a resin providing a precursor for the formation of a coating film which precursor is set by ultraviolet rays (or radiation including light). By way of example but not by way of limitation, these resins are exemplified below.

Referring first to the solvent solution type resin, a solid matter that is a main component for forming a coating film may previously be dissolved in a solvent. Then, the ensuring solution is coated on each member forming a part of a solar photovoltaic generation module, after which the solvent is evaporated off to form a coating film thereby obtaining a desired module having a coating film formed on it. The solid matter used for the solvent solution type resin, for instance, includes an acrylic resin, an epoxy resin, PC (polycarbonate), TAC (triacetylcellulose), PET (polyethylene terephthalate), PVA (polyvinyl alcohol), PVB (polyvinylbutyral), PEI (polyether imide), polyester, EVA (ethylene-vinyl acetate copolymer), PCV (polyvinyl chloride), PI (polyimide), PA (polyamide), PU (polyurethane), PE (polyethylene), PP (polypropylene), PS (polystyrene), PAN (polyacryloriitrile), a butyral resin, ABS (acrylonitrile-butadiene-styrene copolymer), ETFE (ethylene-tetrafluoroethylene copolymer), a fluororesin such as PVF (polyvinyl fluoride), and a silicone resin, which may be used alone or in combinations of two or more. Among others, preference is given to the fluororesin that is good enough in terms of not only water repellency but also the properties as mentioned above. On the other hand, some acceptable effect may also be obtained using other resin(s) although depending on conditions under which they are used, etc. Use may further be made of resin compositions, etc. in which thermosetting capability or ultraviolet or other activation energy radiation setting capability is added to these resins.

Referring then to the thermosetting type resin, a solid matter that is a main component for forming a coating film may previously be dissolved in a solvent. The ensuring solution is coated on each member forming a part of a solar photovoltaic module. Then, the solvent is evaporated off, after which the coated surface is heated at higher than room temperature to form a coating film thereby obtaining a desired module. The solid matter used with the thermosetting type resin, for instance, includes an epoxy resin, a melamine resin, a urea resin, a urethane resin, a polyimide resin, and a polymer of resins such as fluororesin, silazane resin and silicone resin, which may be used alone or in combinations of two or more.

Referring then to the ultraviolet (radiation inclusive of light) setting type resin, a solid matter that is a main component for forming a coating film may previously be dissolved in a solvent. Then, the ensuing solution is coated on each member forming a part of a solar photovoltaic generation module. Then, the solvent is evaporated off, after which'the coated surface is irradiated and set with ultraviolet (radiation inclusive of light) to form a set coating film thereby obtaining the module as desired. In this case, the radiation or electromagnetic wave used for setting is generally an ultraviolet ray, but radiations inclusive of light such as visible light may also be used. The solid matter used with the ultraviolet (or radiation inclusive of light) setting type, for instance, includes a silicone resin, an acrylic resin, an unsaturated polyester resin, an epoxy resin, a fluororesin, an oxetane resin and a polyvinyl ether resin which may be used alone or in combinations of two or more.

For ultraviolet light (or visible light) setting, a high-pressure mercury lamp, a constant-pressure mercury lamp, a thallium lamp, an indium lamp, a metal halide lamp, a xenon lamp, an ultraviolet LED, a blue LED, a white LED, an excimer lamp made by Harison Toshiba Lighting Corporation, and an H bulb, an H plus bulb, a D bulb, a V bulb, a Q bulb and an M bulb, each made by Fusion Co., Ltd., may be used as a light source for emitting light. Besides, solar light may also be used. Note here that setting in the absence of oxygen may be carried out in an atmosphere such as nitrogen gas, carbon dioxide gas, and helium gas.

For ultraviolet setting, the coated surface may further be irradiated with an ultraviolet ray of 200 to 400 nm in a range of preferably 0.1 to 1,000 J/cm². More preferably, an energy beam active for setting is divided into multiple doses for irradiation. That is, as about 1/20 to 1/3 of the total dose is used for the first irradiation and the necessary rest of dose is applied for the second to end irradiations, it results in a set mass having reduced double refraction. Although the irradiation time is optionally variable depending on the amount of the resin used and the degree of setting, yet it is usually adjusted between about 1 second and about 10 minutes.

No particular limitation is imposed on the solvent in which the solid matter used with the solvent solution type, thermosetting type or ultraviolet (or radiation inclusive of light) setting type resin is previously dissolved, with the proviso that it is capable of dissolving or dispersing that solid mass. There are specific mentions of fluoroalcoholic solvents such as CF₃CH₂OH, F(CF₂)₂CH₂OH, (CF₃)₂CHOH, F(CF₂)₃CH₂OF(CF₂)₄C₂H₅OH, H(CF₂)₂CH₂OH, H(CF₂)₃CH₂OH and H(CF₂)₄CH₂OH; f luoroaromatic solvents such as perfluorobenzene and metaxylene hexafluoride; and fluorocarbon solvents such as CF₄(HFC-14), CHClF₂(HCFC-22), CHF₃(HFC-23), CH₂CF₂(HFC-32), CF₃CF₃(PFC-116), CF₂ClCFCl₂(CFC-113), C₃HClF₅(HCFC-225), CH₂FCF₃(HFC-134a), CH₃CF₃(HFC-143a), CH₃CHF₂(HFC-152a), CH₃CCl₂F(HCFC-141b), CH₃CClF₂(HCFC-142b) and C₄F₈(PFC-C318). The dilution ratio here may be adjusted in such a way as to become optimal depending on the resin and solvent used, the thickness of the ensuing coating film, drying conditions, etc. Usually, the dilution ratio for coating film formation is adjusted such that the solid component accounts for 30 to 0.05% by mass of the post-adjustment solvent.

Besides, there are specific mentions of hydrocarbon solvents such as xylene, toluene, solvesso 100, solvesso 150 and hexane; ester solvents such as methyl acetate, ethyl acetate, butyl acetate, ethylene glycol monomethyl ether acetate, ethylene glycol monoethyl ether acetate, ethylene glycol monobutyl ether acetate, diethylene glycol monomethyl ether acetate, diethylene glycol monoethyl ether acetate, diethylene glycol monobuyl ether acetate, ethylene glycol acetate and diethylene glycol acetate; ether solvents such as dimethyl ether, diethyl ether, dibutyl ether, ethylene glycol monomethyl ether, ethylene glycol monoethyl ether, ethylene glycol monobutyl ether, ethylene glycol dimethyl ether, ethylene glycol diethyl ether, ethylene glycol dibutyl ether, diethylene glycol monomethyl ether, diethylene glycol monoethyl ether, diethylene glycol monobutyl ether, diethylene glycol dimethyl ether, diethylene glycol diethyl ether, diethylene glycol dibutyl ether and tetrahydrofuran; ketone solvents such as methyl ethyl ketone, methyl isobutyl ketone and acetone; amide solvents such as N,N-dimethylacetamide, N-methylacetamide, acetamide, N,N-dimethylformamide, N,N-dietylformamide and N-methylformamide; ester sulfonate solvents such as dimethylsulfoxide; methanol; ethanol; isopropanol; butanol; ethylene glycol; diethylene glycol; polyethylene glycol (having a degree of polymerization of 3 to 100). These solvents may be used alone or in combinations of two or more.

It is here noted that among others, preference is given to the aforesaid various alcoholic, fluoro-, ketone and ester solvents in view of solubility, coating film's appearance and storage stability, and particular preference is given to methanol, ethanol, isopropanol, methyl ethyl ketone, methyl isobutyl ketone, cyclohexanone, cellosolve acetate, butyl acetate, ethyl acetate, perfluorobenzene, metaxylene hexafluoride, HCFC-225, CFC-113, HFC-134a, HFC-143a and HFC-142b, which may be used alone or in combination of two or more.

Referring to the formation of the coating film on each structural member, a gap or cleft occurs occasionally between the outer frame member and the transparent substrate member/back sheet member even when butyl rubber or silicone rubber is used as a caulking material on the inside of the outer frame member. For this reason, it is preferable to use the coating film material to create a filling site at the cleft between these structural members. To be specific, it is effective to rely upon a method of impregnating that filling site with a solution of the coating film component, in which case the solvent solution type or thermosetting type resin is preferably used as the solid matter provided for the coating film.

Commercially available products usable as the surface modifier material in the invention described here, for instance, include Teflon (registered trademark) AF Series (DuPont), Tedlar Series (DuPont), Fluon Series (AGC), Cytop (AGC), HiFluon Series (Sovaysolexis), THV Series (Sumitomo 3M), NeoFlon Series (Daikin), Optoace Series (Daikin), Kainer Series (Arkema), Dyneon Series (Dyneon), Marvel Coat (Mitsubishi Gas Chemical), F Top Series (Mitsubishi Materials Electronic Chemicals), and SF Coat (AGC Seimi Chemicals) which may be used alone or in combination of two or more.

Upon coating of the solvent solution type, thermosetting type or ultraviolet setting type solid matter, for instance, cloth or paper impregnated with the aforesaid solution may be used to wipe by hand the surface of each member of the solar photovoltaic generation module, although the preferable may be picked out of existing coating processes. There is a specific mention of printing processes such as screen printing, a gravure coating process, a reverse coating process, a bar coating process, a spray coating process, a knife coating process, a roll coating process and a die coating process, and although depending on conditions, use may also be made of a curtain coating (flow coating) process, a spin coating process, a CVD process, a mist-CVD process, and suchlike. If the optimum is selected from these processes to form the desired coating film, it is then possible to obtain a solar photovoltaic generation module having a coating film formed of the surface modifier material having any desired physical properties.

There is no particular limitation on the thickness of the coating film formed; the coating film thickness may be on the same order as that of coating films formed of ordinary resinous materials. For instance, there is a mention of about 1 to 500 µm. It is also possible to adjust the film thickness of the coating layer in such a way as to obtain the desired physical properties. The concentration of the solid matter in coating solution compositions may be adjusted in such a way as to provide any desired film thickness depending on the specific instrument and apparatus used, solution viscosities, spinner speeds, times allowed for coating, and the like.

The coating film of the surface modifier material is effectively provided on the aforesaid structural members as well as on the aforesaid functional members. If the coating film is provided on the surfaces of the outer frame member, transparent substrate member and back sheet member, it is then possible to eliminate or hold back the PID or snail trails or inconveniences incidental to these defects. To be more specific, all the surfaces of the outer frame member, transparent substrate member and back sheet member are coated with the coating film of the surface modifier material prior to assembling. Then, the respective members are assembled into a solar photovoltaic generation module so that ingress of rainwater or the open air into the solar photovoltaic generation module can be held back to prevent the PIC or snail trail or inconveniences incidental to them. In particular, it is also effective to cover up only the surface or surfaces of at least one or more of the outer frame member, transparent substrate member and back sheet member in contact with air.

The coating film may effectively be provided over the functional members in general, and over the cell assembly in particular. The coating film may be provided at a part or the whole of the surface of the cell member. Alternatively, it is also possible to provide the coating film over a stack of the transparent electrode, photovoltaic layer and back-surface electrode; however, the coating film must then be provided in such a way as to cover over them because of being integral with and on the transparent substrate.

Referring to the material used for each member of the solar photovoltaic generation module, for instance, aluminum is commonly used for the outer frame in consideration of ease of processing and lightness. By way of illustration but not by way of limitation, materials such as glass, polycarbonate, acrylics, polyethylene terephthalate (PET), polyethylene naphthalate (PEN) and polyimide (PI) may be used for the transparent substrate. Specifically but not exclusively, ethylene-vinyl acetate copolymer (EVA), polyvinylbutyral (PVB) and silicone resin may be used for the sealing material to provide protections for the cell assembly and interconnector or the photovoltaic layer, transparent electrode and back-surface electrode. For instance, polyvinyl fluoride (PVF), polyethylene terephthalate (PET), polyethylene (PE), aluminum, and glass may be used alone or in a stacked form for the back sheet to provide a protection for the sealing material or an internal photovoltaic site. Note here that butyl rubber or silicone rubber is used as a caulking material on the inside of the outer frame to provide a protection for the interior of the photovoltaic generation module:

The present invention may be applied to any solar photovoltaic generation module irrespective of its aspect. For instance, the invention may be applied to every solar photovoltaic generation module including a photovoltaic substrate based on a crystal system, an amorphous silicon system, a CIGS or other compound system, or an organic system such as a color sensitizing type or organic thin film type system. In addition to the above-exemplified basic construction or configuration, the invention may make use of various additional elements such as antireflection layers so as to compensate for the necessary functions.

By way of illustration but not by way of limitation, the present invention is now explained more specifically with reference to some examples.

### Examples

### [Example 1]

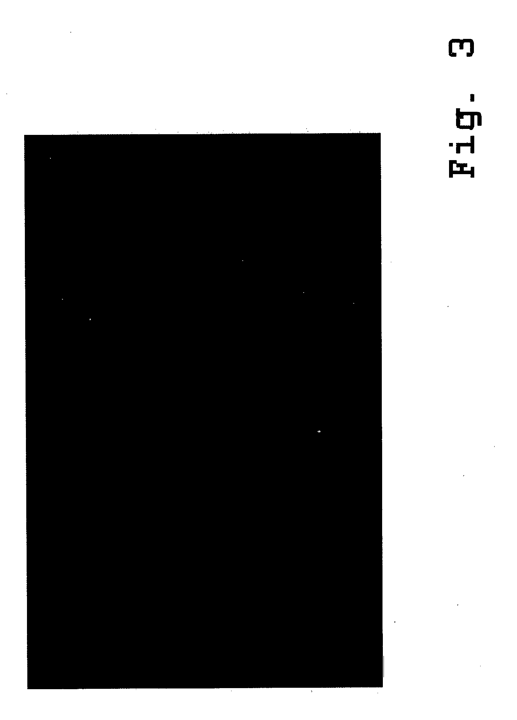

Cloth impregnated with Teflon AF1601S was used to put a coating film on the outer aluminum frame, on the glass transparent substrate, and in clefts between the frame, glass substrate and back sheet of a crystal-system solar photovoltaic generation module (1650mm×990 mm) in such a way as to provide a coating film thickness of about 0.02 to 0.2 µm, and drying was carried out by feeding in hot air by means of a hair drier. The water contact angle (25°C, 40%RH), water sliding angle (25°C, 40%RH) and sheet resistance (25°C, 85% RH) of the glass transparent substrate in the photovoltaic generation module (Inventive Sample 1) having a coating film formed on it were found to be 104.3 degrees, 14.8 degrees and 5.51×10⁴ Ω/sq, respectively. This photovoltaic generation module was permitted to emit light by application of a voltage of - 1000 V and as a result, it was found that all the cells inside emitted light as shown in Fig. 3. This amount of light emission is here used as a reference 100% (reference value).

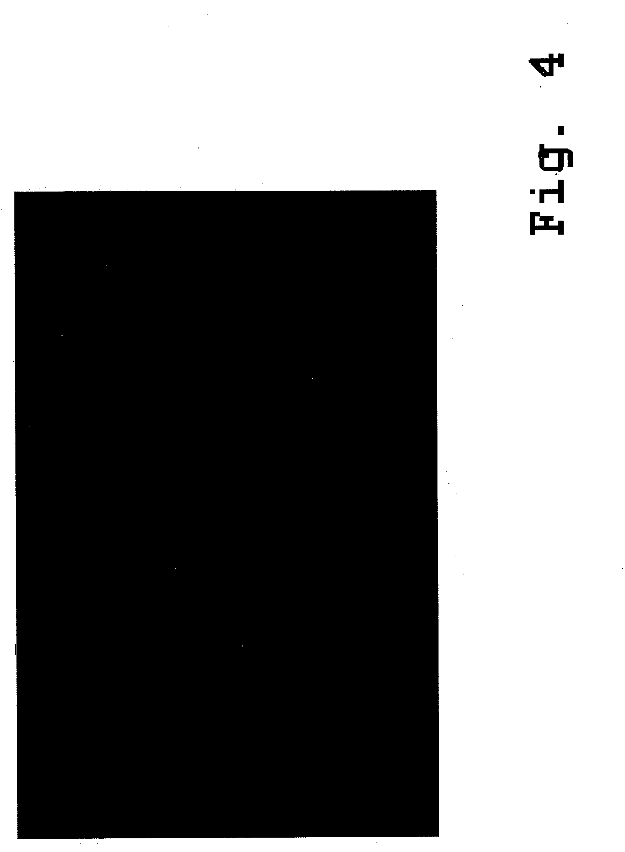

After this photovoltaic generation module was left standing for 150 hours while exposed to high-temperature and high-humidity conditions (85°C, 85% RH) in a temperature/humidity control apparatus such as a thermo-hygrostat, It was taken out of that apparatus. Then, the application of a -1000 V voltage as previously stated caused the module to emit light as shown in Fig. 4. The amount of light emission was then 98% as compared with before exposed to the high-temperature and high-humidity conditions.

### [Comparative Example 1]

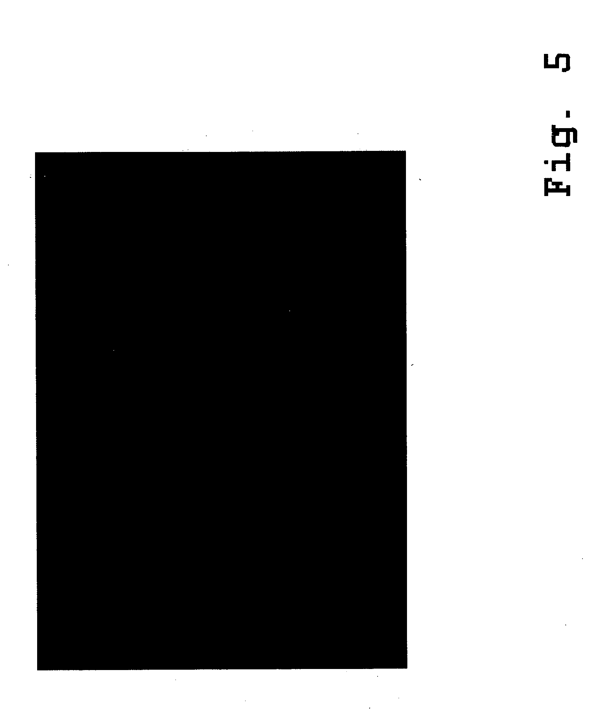

In the same lot as mentioned above, -1000 V were applied to a solar photovoltaic generation module having no coating film on in (Comparative Sample 1), as in Example 1, to obtain a 100% light emission that is here set as a reference value. After the module was left standing for 96 hours while exposed to high-temperature and high-humidity conditions (85°C, 85% RH) as in Example 1, that module was removed out. Then, the application of -1000 volts as in Example 1 resulted in only a 2% light emission as compared with the reference value, as shown in Fig. 5.

### [Example 2]

Cloth impregnated with Teflon AF1601S was used to put a coating film on the outer aluminum frame and on the glass transparent substrate of a crystal-system solar photovoltaic generation module (1650mm×990 mm) in the same lot as in Example 1 in such a way as to provide a coating film thickness as in Example 1, and drying was carried out by feeding in hot air by means of a hair drier. The water contact angle (25°C, 40%RH), water sliding angle (25°C, 40%RH) and sheet resistance (25°C, 85% RH) of the glass transparent substrate in the photovoltaic module (Inventive Sample 2) having a coating film formed on it were found to be 104.5 degrees, 14.1 degrees and 4.91×10⁴ Ω/sq, respectively. This photovoltaic generation module was permitted to emit light by application of a voltage of -1000 V and as a result, it was found that all the cells inside emitted light. This amount of light emission is here used as a reference 100% (reference value).

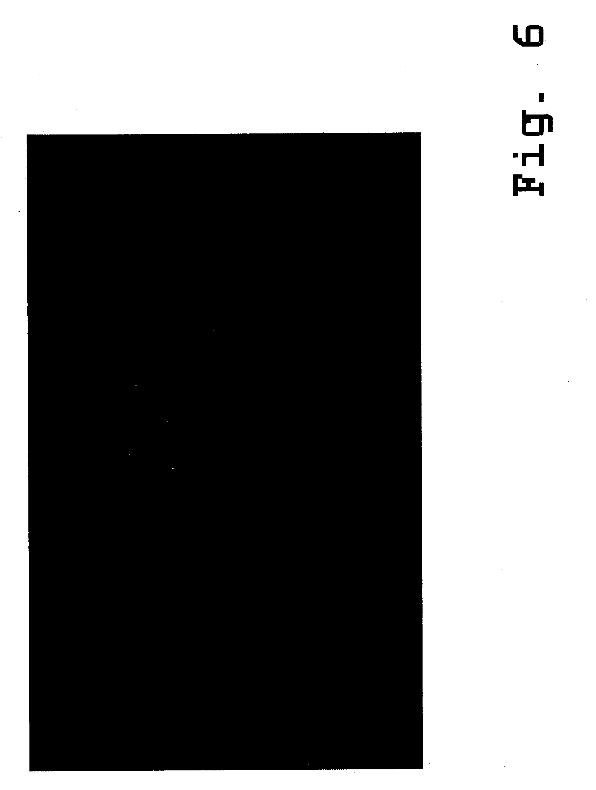

After this photovoltaic generated module was left standing for 130 hours while exposed to high-temperature and high-humidity conditions (85°C, 85% RH) in a temperature/humidity control apparatus such as a thermohygrostat, it was taken out of that apparatus. Then, the application of a -1000 V voltage as previously stated caused the module to emit light as shown in Fig. 6. The amount of light emission was then 97% as compared with before exposed to the high-temperature and high-humidity conditions.

### [Example 3]

Cloth impregnated with Teflon AF1601S was used to put a coating film on the outer aluminum frame and on the glass transparent substrate of a crystal-system solar photovoltaic generation module (1650mm×990 mm) in the same lot as in Example 1 in such a way as to provide a similar coating film thickness as in Example 1, and drying was carried out by feeding in hot air by means of a hair drier. The water contact angle (25°C, 40%RH), water sliding angle (25°C, 40%RH) and sheet resistance (25°C, 85% RH) of the glass transparent substrate in the photovoltaic generation module (Inventive Sample 3) having a coating film formed on it were found to be 108.1 degrees, 9.7 degrees and 7.15×10⁴ Ω/sq, respectively. This photovoltaic module was permitted to emit light by application of a voltage of -1000 V and as a result, it was found that all the cells inside emitted light. This amount of light emission is here used as a reference 100% (reference value).

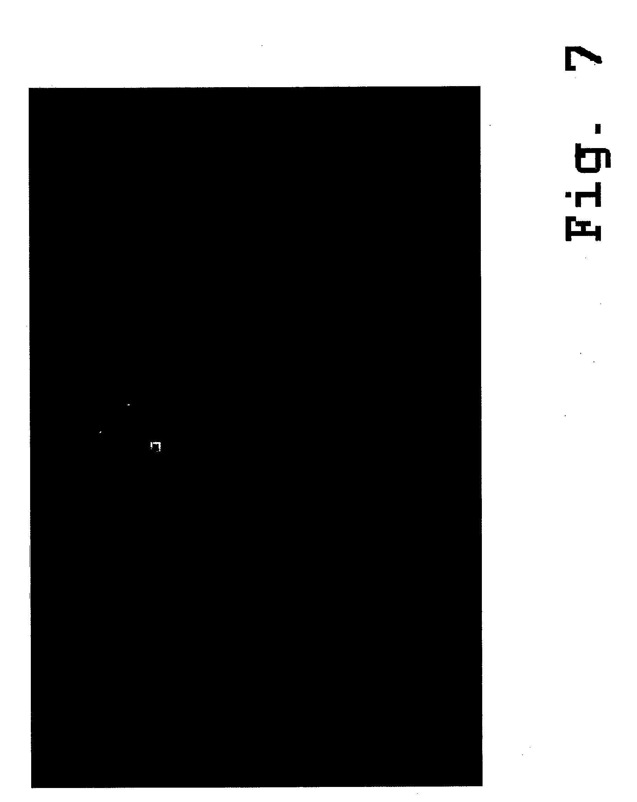

After this photovoltaic generation module was left standing for 100 hours while exposed to high-temperature and high-humidity conditions (85°C, 95% RH) as in Example 1, it was removed. Then, the application of a -1000 V voltage to that module resulted in light emission as shown in Fig. 7. The amount of light emission was then 98% as compared with before exposed to the high-temperature and high-humidity conditions.

### [Example 4]

Cloth impregnated with Marvel Coat RFH-05X was used to put a coating film on the outer aluminum frame and on the glass transparent substrate of a crystal-system solar photovoltaic generation module (1650mm×990 mm) in the same lot as in Example 1 in such a way as to provide a similar coating film thickness as in Example 1, and drying was carried out by feeding in hot air by means of a hair drier. The water contact angle (25°C, 40%RH), water sliding angle (25°C, 40% RH) and sheet resistance (25°C, 85% RH) of the glass transparent substrate in the photovoltaic generation module (Inventive Sample 4) having a coating film formed on it were found to be 109.5 degrees, 10.9 degrees and 1.15×10⁴ Ω/sq, respectively. This photovoltaic generation module was permitted to emit light by application of a voltage of -1000 V and as a result, it was found that all the cells inside emitted light. This amount of light emission is here used as a reference 100% (reference value).

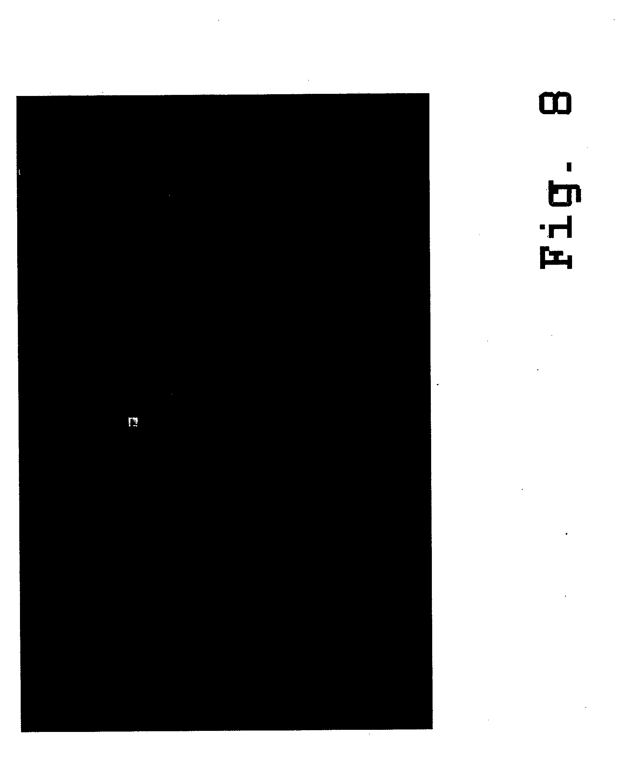

After this photovoltaic generation module was left standing for 120 hours while exposed to high-temperature and high-humidity conditions (85°C, 85% RH) as in Example 1, it was removed. Then, the application of a -1000 V voltage to that module resulted in light emission as shown in Fig. 8. The amount of light emission was then 99% as compared with before exposed to the high-temperature and high-humidity conditions.

### [Example 5]

Cloth impregnated with a butyl acetate solution in which 4 mass% of polymethyl methacrylate were dissolved was used to put a coating film on the outer aluminum frame and on the glass transparent substrate of a crystal-system solar photovoltaic generation module (1650mmX990 mm) in the same lot as in Example 1 in such a way as to provide a similar coating film thickness as in Example 1, and drying was carried out by feeding in hot air by means of a hair drier. The water contact angle (25°C, 40% RH), water sliding angle (25°C, 40% RH) and sheet resistance (25°C, 85% RH) of the glass transparent substrate in the photovoltaic generation module (Inventive Sample 5) having a coating film formed on it were found to be 67.5 degrees, 49.7 degrees and 1.15×10² Ω/sq, respectively. This photovoltaic module was permitted to emit light by application of a voltage of -1000 V and as a result, it was found that all the cells inside emitted light. This amount of light emission was here used as a reference 100% (reference value).

After this photovoltaic generation module was left standing for 15 hours while exposed to high-temperature and high-humidity conditions (85°C, 95% RH) as in Example 1, it was removed. Then, the application of a -1000 V voltage to that module resulted in light emission. The amount of light emission was then 95% as compared with before exposed to the high-temperature and high-humidity conditions.

### [Example 6]

Cloth impregnated with Marvel Coat RFH-05X was used to put a coating film on the outer aluminum frame and on the glass transparent substrate of a crystal-system solar photovoltaic generation module (1650mm×990 mm) in the same lot as in Example 1 in such a way as to provide a similar coating film thickness as in Example 1, and drying was carried out by feeding in hot air by means of a hair drier. The water contact angle (25°C, 40%RH), water sliding angle (25°C, 40%RH) and sheet resistance (25°C, 85% RH) of the glass transparent substrate in the photovoltaic generation module (Inventive Sample 6) having a coating film formed on it were found to be 109.3 degrees, 10.5 degrees and 0.97×10³ Ω/sq, respectively. This photovoltaic generation module was permitted to emit light by application of a voltage of -1000 V and as a result, it was found that all the cells inside emitted light. This amount of light emission is here used as a reference 100% (reference value).

After this photovoltaic generation module was left standing for 30 hours while exposed to high-temperature and high-humidity conditions (85°C, 85% RH) as in Example 1, it was removed. Then, the application of a -1000 V voltage to that module resulted in light emission. The amount of light emission was then 96% as compared with before exposed to the high-temperature and high-humidity conditions.

### [Example 7]

Cloth impregnated with Marvel Coat RFH-05X was used to put a coating film on the outer aluminum frame and on the glass transparent substrate of a crystal-system solar photovoltaic generation module (1650mmX990 mm) in the same lot as in Example 1 in such a way as to provide a similar coating film thickness as in Example 1, and drying was carried out by feeding in hot air by means of a hair drier. The water contact angle (25°C, 40% RH), water sliding angle (25°C, 40% RH) and sheet resistance (25°C, 85% RH) of the glass transparent substrate in the photovoltaic generation module (Inventive Sample 7) having a coating film formed on it were found to be 108.3 degrees, 11.2 degrees and 4.15×10³ Ω/sq, respectively. This photovoltaic module was permitted to emit light by application of a voltage of -1000 V and as a result, it was found that all the cells inside emitted light. This amount of light emission was here used as a reference 100% (reference value).

After this photovoltaic generation module was left standing for 30 hours while exposed to high-temperature and high-humidity conditions (85°C, 85% RH) as in Example 1, it was removed. Then, the application of a -1000 V voltage to that module resulted in light emission. The amount of light emission was then 95% as compared with before exposed to the high-temperature and high-humidity conditions.

### [Example 8]

Cloth impregnated with Marvel Coat RFH-05X was used to put a coating film on the outer aluminum frame and on the glass transparent substrate of a crystal-system solar photovoltaic generation module (1650mm×990 mm) in the same lot as in Example 1 in such a way as to provide a similar coating film thickness as in Example 1, and drying was carried out by feeding in hot air by means of a hair drier. This photovoltaic generation module (Inventive Sample 8) having a coating film formed on it was permitted to emit light by application of a voltage of -1000 V and as a result, it was found that all the cells inside emitted light. This amount of light emission was here used as a reference 100% (reference value).

After this photovoltaic generation module was left standing for 30 hours while exposed to high-temperature and high-humidity conditions (85°C, 85% RH) as in Example 1, it was removed. Then, the application of a -1000 V voltage to that module resulted in light emission. The amount of light emission was then 94% as compared with before exposed to the high-temperature and high-humidity conditions.

### Applicability to the Industry

The present invention may be used with various types of solar photovoltaic generation modules to maintain performance over an extended period of time and improve photovoltaic regardless of the types of photovoltaic generation substrates inclusive of those based on silicon systems such as single crystal, polycrystal and amorphous silicon semiconductor systems and compound systems such as CIGS systems as well as those based on organic systems such as color sensitizing or organic thin film systems. The present invention may also be applied to not only solar photovoltaic generation modules with solar light as an energy source but also photovoltaic generation modules with indoor artificial light as an energy source.

### Explanation of Reference Numerals

- 11:: Outer frame
- 12:: Transparent substrate
- 13:: Sealing material
- 14:: Cell assembly
- 15:: Interconnector
- 16:: Back sheet
- 101:: Outer frame
- 102:: Transparent substrate
- 103:: Sealing material
- 104:: Photovoltaic layer
- 105:: Transparent electrode
- 106:: Back-surface electrode
- 107:: Back sheet

## Claims

1. A solar photovoltaic generation module, comprising:
at least an outer frame, a transparent substrate, a sealing material and a back sheet, each working as a structural member, and either one of the following functional member combinations: (A) a cell and an interconnector, and (B) a transparent electrode, a photovoltaic layer and a back-surface electrode, wherein at least a part or the whole of the surface of any one of said members is covered with a coating film of a water-repellent surface modifier material.

2. A solar photovoltaic generation module as recited in claim 1, wherein the coating film of said surface modifier material has a sheet resistance of at least 100 Ω/sq under a condition having a 85% RH humidity.

3. A solar photovoltaic generation module as recited in claim 1, wherein a water contact angle of the coating film of said surface modifier material is greater than 50 degree.

4. A solar photovoltaic generation module as recited in claim 1, wherein the coating film of said surface modifier material has a water sliding angle of 0.5 degree to 60 degrees inclusive.

5. A solar photovoltaic generation module as recited in claim 1, wherein the coating film of said surface modifier material has a refractive index equal to or less than that of said transparent substrate member and cell member.

6. A solar photovoltaic generation module as recited in claim 1, wherein the coating film of said surface modifier material has a light ray transmittance equal to or greater than that of the transparent substrate member and cell member.

7. A solar photovoltaic generation module as recited in claim 1, wherein said surface modifier material is any one of a solvent solution type resin, a thermosetting type resin, and an ultraviolet setting type resin.

8. A solar photovoltaic generation module as recited in claim 1, wherein the coating film of said surface modifier material is formed on the surface of one or two or more members selected from said outer frame member, said transparent substrate member, and said back sheet member.

9. A solar photovoltaic generation module as recited in claim 8, wherein the coating film of said surface modifier material is formed on a portion of each member coming into contact with air.

10. A solar photovoltaic generation module as recited in claim 1, wherein the coating film of said surface modifier material is formed on a part or the whole of the surface of the cell member.

11. A solar photovoltaic generation module as recited in claim 1, wherein the coating film of said surface modifier material is formed on a part or the whole of the inside of the substrate.
